Europäisches Patentamt

European Patent Office

Office européen des brevets

(19)

(11) Publication number: **0 350 294**
**A2**

## (12) EUROPEAN PATENT APPLICATION

(21) Application number: **89306837.9**

(22) Date of filing: **05.07.89**

(51) Int. Cl.[5]: **H 01 L 39/24**

(30) Priority: **05.07.88 JP 167059/88**
**05.07.88 JP 167060/88**
**02.11.88 JP 277711/88**
**13.01.89 JP 6375/89**
**05.06.89 JP 143558/89**
**13.01.89 JP 6376/89**

(43) Date of publication of application:
**10.01.90 Bulletin 90/02**

(84) Designated Contracting States: **DE FR GB**

(71) Applicant: **SEMICONDUCTOR ENERGY LABORATORY**
**CO., LTD.**
**398 Hase**
**Atsugi-shi Kanagawa-ken, 243 (JP)**

(72) Inventor: **Takemura, Yasuhiko**
**Flat Atsugi 208 931-1, Hase**
**Atsugi-shi Kanagawa-ken (JP)**

(74) Representative: **Milhench, Howard Leslie et al**
**R.G.C. Jenkins & Co. 26 Caxton Street**
**London SW1H 0RJ (GB)**

(54) **Method of manufacturing superconducting oxide materials.**

(57) Superconducting oxide ceramics, particularly those that are based upon Bismuth (Bi), can be different to form in the requisite structure and the invention proposes a method according to which a ceramic which is easier to make and has a similar molecular structure is used as a starting material to initiate and/or encourage the development of the superconducting ceramic material as desired. For example, superconducting ceramics may be produced in crystalline form by use of a crystal pulling technique in which a seed crystal is easily prepared from another ceramic material which is non-superconducting but has a similar molecular structure to that of the required superconducting ceramic. By virtue of the similarity in the crystalline structure, single crystals of superconducting ceramic materials can easily be produced. Similarly, superconducting ceramic material can be formed upon a substrate of a non-superconducting ceramic material having a similar molecular structure.

EP 0 350 294 A2

Bundesdruckerei Berlin

**Description**

## Method of Manufacturing Superconducting Oxide Materials

### BACKGROUND OF THE INVENTION

The present invention relates to a method of manufacturing oxide superconductor elements, and more particularly though not exclusively to a method of manufacturing Bi-based superconducting ceramic materials.

Recently, superconducting ceramics comprising Bi have been discovered as promising materials which can be formed to have a high Tc. These Bi-based superconducting materials take two phases, in one of which, called the low Tc phase, the critical temperature reaches up to $80°K$, and in the other, called the high Tc phase, the critical temperature reaches up to $110°K$. The stoichiometric formula of an example of the low Tc ceramic is $Bi_2Sr_2CaCu_2O_{8-x}$ and this material has a c-axis length of 30 Å. The stoichiometric formula of an example of the high Tc ceramic is $Bi_2Sr_2Ca_2Cu_3O_{10-x}$ and this material has a c-axis length of 36 Å. In this low Tc phase, there are formed three CuO planes within one unit structure thereof. In accordance with recent reports, other phases having c-axis lengths of 42 Å and 48 Å also exist and in these phases $CuO$-(Sr, Ca) planes are formed in addition to the three CuO planes. It is believed that these are the reason for the fact that the resistivity of Bi-based superconductors begins to fall down at $150°K$ or higher temperatures.

In spite of past efforts, it has still been difficult to increase the proportions of the high Tc phase in the formation of Bi-based superconducting ceramics. Also, single crystals of the high Tc phase have not hitherto been formed.

### OBJECTS AND SUMMARY OF THE INVENTION

It is therefore an object of the present invention to provide an improved method of producing high Tc superconducting ceramic materials.

The present invention achieves the abovementioned object by utilizing as a starting material for the superconducting material that is required to be formed a more readily formed or already available material which need not itself be superconducting and has a molecular structure which is similar to that of the required superconducting material. By use of the starting material as a substrate upon which the superconducting material is deposited, for example, or as a seed crystal for development of a superconducting material by a crystal pulling technique, for example, the molecular structure of the starting material can act as a template or pattern for development of the superconducting material whereby a preferential phase development in the superconducting material can be achieved.

Described hereinafter are various embodiments of the invention wherein seed crystals or substrates are prepared from other materials which can be easily formed and have molecular structures similar to those of the required superconducting ceramics. For example, Bi-based layered dielectrics expressed by the general formula $(Bi_2O_2)(A_{m-m}B_mO_{3m+1})$ where $m > 1$, A stands for an alkaline earth metal such as Ca and B stands for a rare earth element such as Ti tend to have very similar structures to superconducting ceramics and are useful as starting materials in the practice of the present invention. The a-axis lengths and the b-axis lengths thereof are almost equal to those of Bi-based superconducting ceramics. These oxides are not superconducting but their formation is easier than the formation of superconducting ceramics. Among these starting materials are $Bi_2(Sr_{1-x}La_{x4}Cu_3O_y(x = 0.05-0.4, y = 8-12$; c-axis length 32.8 Å, $Bi_4Ti_3O_{12}$ (c-axis length 32.8 Å), $CaBi_4Ti_4O_{15}$ (c-axis length 41-42 Å, $SrBi_4Ti_4O_{15}$ (c-axis length 41-42 Å), $BaBi_4Ti_4O_{15}$ (c-axis length 41-42 Å), $PbBi_4Ti_4O_{15}$ (c-axis length 41-42 Å), $Sr_2Bi_4Ti_5O_{18}$ (c-axis length 48.8 Å), $Ba_2Bi_4Ti_4O_{18}$ (c-axis length 50.3 Å); and $Pb_2Bi_4Ti_5O_{18}$ (c-axis length 49.7 Å). When a superconducting ceramic material is desired to be formed, a suitable starting ceramic material (also called a seed ceramic material hereinafter) may first be selected, e.g. from among the above materials, to have its c-axis length close to that of the superconducting ceramic material that is required to be formed thereon. As an illustration, superconducting $Bi_2(Sr, Ca)_6Cu_5O_{14+x}$ has a c-axis length of 48 Å. According to this method, the high Tc phase can be selectively formed on the seed ceramic.

Alternatively, the seed ceramic material can be selected to have its c-axis length bearing a simple ratio, such as n/m (where n and m are integers and $n < m$), to the c-axis length of the superconducting ceramic material required to be formed. For example, it was observed that a high Tc phase superconductor of 36 Å c-axis length was selectively grown by virtue of the existence of a semiconductor phase of 24 Å c-axis length. Namely, 24:36 = 2:3. Seed ceramics whose c-axis lengths constitute a simple ratio to those of superconducting ceramics are, for example, $Bi_3TiNbO_9$ (c-axis length 25 Å), $Bi_3TiTaO_9$ (c-axis length 25 Å), $Bi_3Ti_4NbO_9$ (c-axis length 25 Å), $CaBi_2Nb_2O_9$ (c-axis length 25 Å), $Bi_3TiTaO_9$ (c-axis length 25 Å), $CaBi_2Ta_2O_9$ (c-axis length 25 Å), $SrBi_2Nb_2O_9$ (c-axis length 25 Å), $SrBi_2Ta_2O_9$ (c-axis length 25 Å), $Ba_2Bi_2Nb_2O_9$ (c-axis length 25 Å), $CaSr_2Bi_4Ti_5O_{18}$ (c-axis length 49-50 Å), $Sr_2Bi_4Ti_5O_{18}$ (c-axis length 49-50 Å), $Ba_2Bi_4Ti_5O_{18}$ (c-axis length 49-50 Å), $Pb_2Bi_4Ti_5O_{18}$ (c-axis length 49-50 Å).

Furthermore, we have found new compound oxide materials which can be represented generally by the formula $Bi_2LaCa_nCu_nO_y$ (n = 1, 2 or 3; y = 8 - 12, called BLCCO hereinafter) and have the same molecular structures as Bi-based superconducting ceramics. Seed crystals of this type could be effectively used for forming single crystals of superconducting ceramics. The a-axis length and the b-axis length of such seed ceramics are the same as for Bi-based superconducting ceramic, and the c-axis lengths are 24 Å (n = 1), 30 Å (n = 2) and 36 Å (n = 3) which are equal to the corresponding figures for superconducting ceramics of the form $Bi_2Sr_2Ca_{n-1}Cu_nO_y$ ($n = 1$, 2 or 3, $y = 8 - 12$). With this seed crystal, single crystalline superconducting ceramics can be formed on the order of 2 cm.

Further features of the invention are set forth with particularly in the appended claims and, together with the abovementioned features, will hereinafter be described in detail with reference to the accompanying drawings and by reference to exemplary embodiments in order that the invention and the advantages thereof might be well understood.

## BRIEF DESCRIPTION OF THE DRAWINGS

Fig.1 is a graphical diagram showing the variation of the resistivity with changing temperature of a first exemplary superconducting ceramic manufactured in accordance with the present invention;

Fig.2 is a graphical diagram showing the variation of the resistivity with changing temperature of a second exemplary superconducting ceramic manufactured in accordance with the present invention;

Fig.3 is a graphical diagram showing the variation of the magnetization with changing temperature of the abovementioned second superconducting ceramic;

Fig.4 is a schematic diagram showing a crystal pulling apparatus for use in the practice of the present invention;

Fig.5 is a graphical diagram showing the variation in the resistivity with changing temperature of a fifth exemplary superconducting ceramic manufactured in accordance with the present invention; and

Fig.6 is a schematic diagram showing a laser sputtering apparatus for use in the practice of the present invention.

## DETAILED DESCRIPTION OF THE EMBODIMENTS

Hereinbelow, the practice of the invention is first illustrated by reference to three exemplary embodiments making use of screen press printing:

Example 1:

$Bi_2O_3$ and $TiO_2$ powders of 99.9% purity were prepared and mixed with each other. After firing at 800°C for 12 hours in air, the mixture was compacted into a circular tablet of 1 mm thickness and 20 mm diameter. The tablet was fired again at 1000°C for 12 hours in air. It was confirmed by means of x-ray diffraction that the stoichiometric composition of the tablet was in the single phase of $Bi_4Ti_3O_{12}$. The c-axis length of $Bi_4Ti_3O_{12}$ is 32.8 Å.

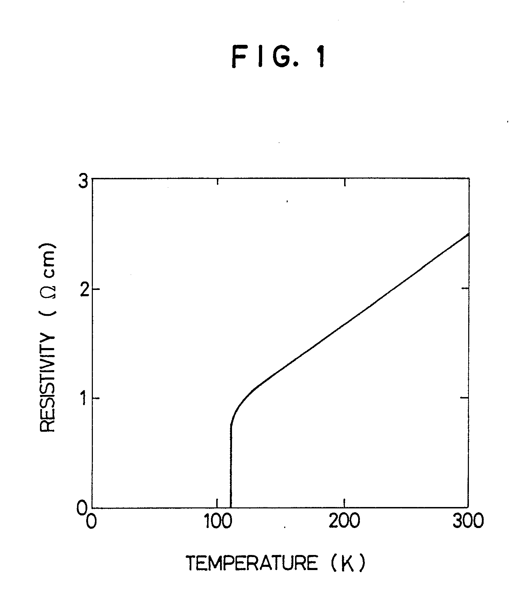

Next, $Bi_2O_3$, $SrCO_3$, $CaCO_3$ and $CuO$ in prescribed amounts were prepared in powder form (99.9% purity) and mixed with each other so that $Bi:Sr:Ca:Cu = 2:2:2:3$. The mixture was fired at 800°C for 12 hours in air and ground into powder of 1-5 micrometers average diameter. The powder was mixed with ethanol and applied to the surface of the $Bi_4Ti_3O_{12}$ tablet in film form by screen printing. The film was fired at 900°C for 30 min and gradually cooled at 60°C/hour to room temperature. The thickness of the film was measured to be 30 micrometers. The c-axis was measured to be 36 Å. Fig.1 shows the resistivity of the film as a function of temperature. As shown in the figure, the critical temperature was 110°K. By means of X-ray diffraction, the film was proved to be in the high Tc phase of $Bi_2Sr_2Ca_2Cu_3O_{10+x}$. The critical superconducting current density was measured to be 50,000 A/cm$^2$.

Example 2:

$SiCO_3$, $Bi_2O_3$ and $TiO_2$ powders of 99.9% purity were prepared and mixed with each other. After firing at 800°C for 12 hours in air, the mixture was compacted into a circular tablet of 1 mm thickness and 20 mm diameter. The tablet was fired again at 1000°C for 12 hours in air. It was confirmed by means of x-ray diffraction that the stoichiometric composition of the tablet was $SR_2Bi_4Ti_5O_{18}$ including a small amount of $SR_2Bi_4Ti_4O_{15}$. The c-axis length of $Sr_2Bi_4Ti_5O_{18}$ is 49-50 Å.

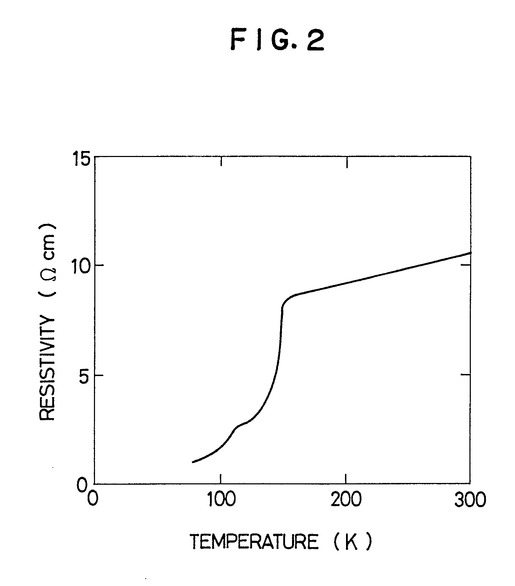

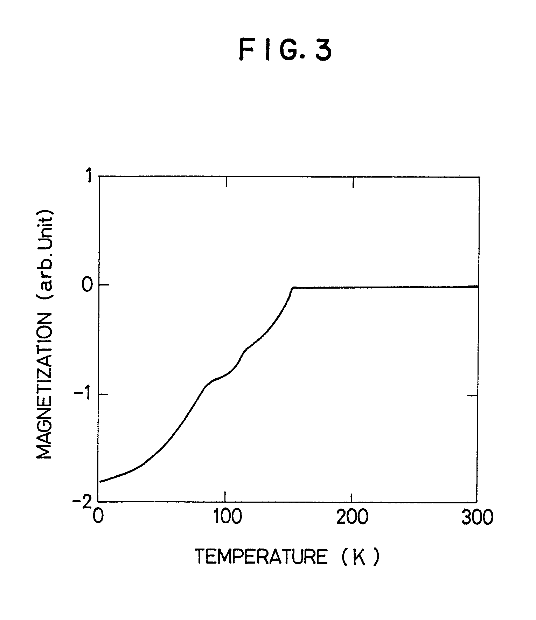

Next, $Bi_2O_3$, $SrCO_3$, $CaCO_3$ and $CuO$ in prescribed amounts were prepared in powder form (99.9% purity) and mixed with each other so that $Bi:Sr:Ca:Cu = 2:3:3:5$. The mixture was fired at 800°C for 12 hours in air and ground into powder of 1-5 micrometers average diameter. The powder was mixed with ethanol and applied to the surface of the $Sr_2Bi_4Ti_5O_{18}$ tablet in film form by screen printing. The film was fired at 900°C for 30 min and gradually cooled at 60°C/hour to room temperature. The thickness of the film was measured to be 30 micrometers. The c-axis was measured to be not shorter than 40 Å. Fig.2 shows the resistivity of the film as a function of temperature. As shown in the figure, the critical temperature was 110°K. By means of X-ray diffraction, the film was proved to be in the high Tc phase of $(Bi_2O_2)(Sr_3Ca_3Cu_5O_{18+x})$. The presence of the Meisner effect was confirmed by measuring magnetization using a SQUID, namely, as illustrated in Fig.3, the magnetization became negative when cooled below about 150K. The proportion of the high Tc phase (Tc = 150°K) was estimated from the magnetization curve to be 3 to 8% which provides improved superconducting properties. The critical superconducting current density was measured to be 50,000 A/cm$^2$.

Example 3:

$Nb_2O_5$, $Bi_2O_3$ and $TiO_2$ powders of 99.9% purity were prepared and mixed with each other. After firing at 800°C for 12 hours in air, the mixture was compacted into a circular tablet of 1 mm thickness and 20 mm diameter. The tablet was fired again at 1000°C for 12 hours in air. It was confirmed by means of x-ray diffraction that the stoichiometric composition of the tablet was in the single phase of $Bi_3TiNbO_9$. The c-axis length of $Bi_3TiNbO_9$ is 25.1 Å.

Next, $Bi_2O_3$, $SrCO_3$, $CaCO_3$ and $CuO$ in prescribed amounts were prepared in powder form (99.9% purity) and mixed with each other so that $Bi:Sr:Ca:Cu = 2:2:2:3$. The mixture was fired at 800°C for 12 hours in air and ground into powder 1-5 micrometers average diameter. The powder was mixed with ethanol and applied to the surface of the $Bi_3TiNbO_9$ tablet in film form by screen printing. The film was fired at 900°C for 30 min and gradually cooled at 60°C/hour to room temperature. The thickness of the film was measured to be 30 micrometers. The c-axis was measured to be 36 Å. The the critical temperature was found to be as low as 100°K. By means of X-ray diffraction, the film was proved to be in the high Tc phase of $Bi_2Sr_2Ca_2Cu_3O_{10+x}$. The critical superconducting current density was measured to be as high as about 40,000 $A.CM^2$.

Superconducting ceramics can also be formed in accordance with the present invention by a crystal pulling technique as described in the following three examples:

Example 4:

$Bi_2O_3$ and $TiO_2$ powders of 99.9% purity were prepared and mixed with each other. The mixture was kept in a crucible made of alumina at 1200°C for seven days, and then crushed, from which crushed material a seed crystal of $Bi_4Ti_3O_{12}$ was selected and taken up. The size of the crystal was of the order of about 3 mm x 3 mm x 1 mm.

Next, $Bi_2O_3$, $SrO_3$, $CaCO_3$ and $CuO$ in prescribed amounts were prepared in powder form (99.9% purity) and mixed with each other so that $Bi:Sr:Ca:Cu = 4:2:2:3$. The mixture was fired at 800°C for 12 hours in air and was melted in a crucible at 890°C. A superconducting crystal was produced from the fired mixture by a crystal pulling technique as described hereinbelow.

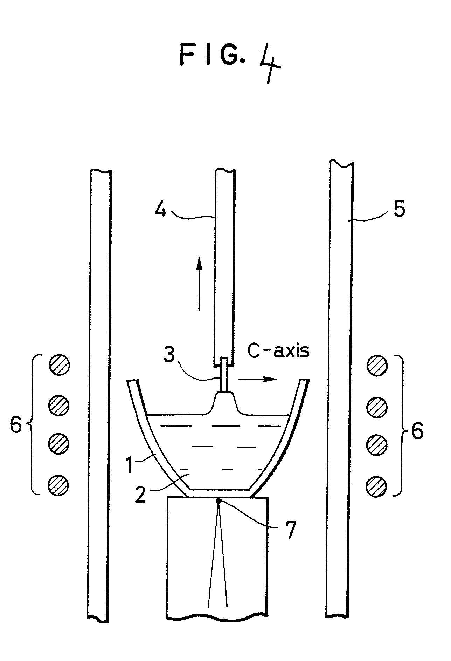

Fig.4 illustrates the furnace construction which was used for the crystal growth in accordance with the present invention. The ceramic mixture 2 was placed in a crucible 1 seated on a ceramic base. A thermocouple is embedded in the base in order to measure the temperature of the crucible 1. A quartz tube was provided surrounding the base and the crucible. An r.f. coil 6 outside the tube then completes the assembly.

The charge in the crucible 1 was molten at 890°C. The seed crystal was supported by a rod 4 so that its c-axis was oriented parallel with the surface of the molten ceramic. Then the seed crystal was pulled up at 5 mm/hour. As a result, a single crystalline Bi-based superconducting ceramic as large as 5 mm x 30 mm x 0.5 mm was obtained. The critical temperature of the superconductor was found to be as low as about 100°K. The critical superconducting current density was measured to be as high as about 40,000 $A.cm^2$.

Example 5:

$Bi_2O_3$, $La_2O_3$, $CaCO_3$ and $CuO$ powders of 99.9% purity were prepared and mixed with each other so that $Bi:La:Ca:Cu - 2:1:2:1$. The mixture was kept in a crucible made of alumina at 1000°C for an hour, followed by gradual cooling at 10°C/hour, and then crushed, from which crushed material a seed crystal of $Bi_2LaCa_2Cu_2O_y$ was selected and taken up. The size of the crystal was about 3 mm x 3 mm x 1 mm.

Next, $Bi_2O_3$, $SrCO_3$, $CaCO_3$ and $CuO$ in prescribed amounts were prepared in powder form (99.9% purity) and mixed with each other so that

$Bi:Sr:Ca:Cu = 1:1:1:3$. The mixture was fired at 800°C for 12 hours in air and was melted in a crucible at 890°C. A superconducting crystal was produced from the molten raw material by the crystal pulling technique.

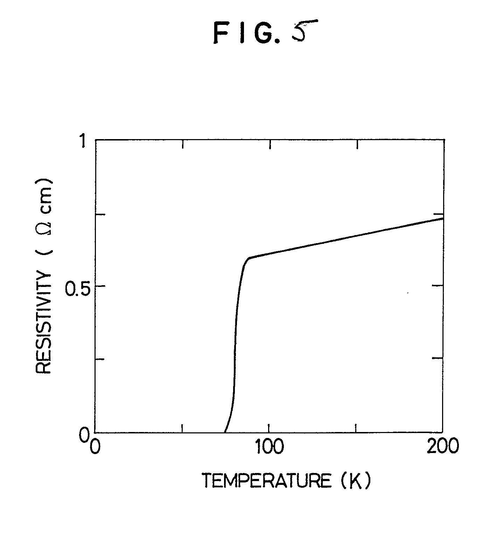

The charge in the crucible was molten at 890°C. The seed crystal was supported by a rod 4 so that its c-axis was adjusted parallel with the surface of the molten ceramic. Then the seed crystal was pulled up at 5 mm/hour. As a result, a single crystalline Bi-based superconducting ceramic as large as 20 mm x 20 mm x 0.5 mm was obtained. Fig.5 shows the resistivity of the crystal as a function of temperature. As shown in the figure, the critical temperature was 82°K. The critical superconducting current density was measured to be 10,000 $A/cm^2$.

Example 6:

The ceramics represented by $Bi_2(Sr_{1-x}La_x)_4Cu_3O_y$ (x = 0.05-0.4, y = 8-12; c-axis length 32.8 Å) have the same structure as the high Tc phase of the Bi-based superconducting ceramics. The a-axis and b-axis lengths are 5.4 Å and 3.6 Å, which are equal to the corresponding figures for the Bi-based superconducting ceramics. These materials, however, can not exhibit superconductivity since the carrier density therein is too low.

The $Bi_2(Sr_{1-x}La_x)_4Cu_3O_y$ ceramic was prepared by a flux method with $CuO$ as a melting agent. First, $Bi_2O_3$, $SrCO_3$, $La_2O_3$, and $CuO$ powders of 99.9% purity were prepared and mixed with each other so that $Bi:Sr:La:Cu = 2:3.5:0.5:3$. The mixture was placed in a crucible and fired at 1000°C for 5 hours followed by gradual cooling to 800°C at 10°C/hour. Then, the cooled charge was crushed in order to pick up a suitable seed crystal therefrom.

Next, $Bi_2O_3$, $SrCO_3$, $CaCO_3$ and $CuO$ in prescribed amounts were prepared in powder form (99.9% purity) and mixed with each other so that $Bi:Sr:Ca:Cu = 4:2:2:3$. The mixture was fired at 800°C for 12 hours in air and was melted in a crucible at 890°C. A superconducting crystal was produced from the molten material by the crystal pulling technique.

The charge in the crucible was molten at 890°C. The seed crystal was supported by a rod 4 so that its c-axis was adjusted parallel with the surface of the molten ceramic. Then the seed crystal was pulled up at 5 mm/hour. As a result, a single crystalline Bi-based superconducting ceramic of 5 mm x 50 mm x 0.5 mm was obtained. The critical temperature was measured to be 106°K. The critical superconducting current density was measured to be 50,000 $A/cm^2$.

Superconducting ceramics can also be formed in accordance with the present invention by a laser sputtering technique as described in the following two examples:

Example 7:

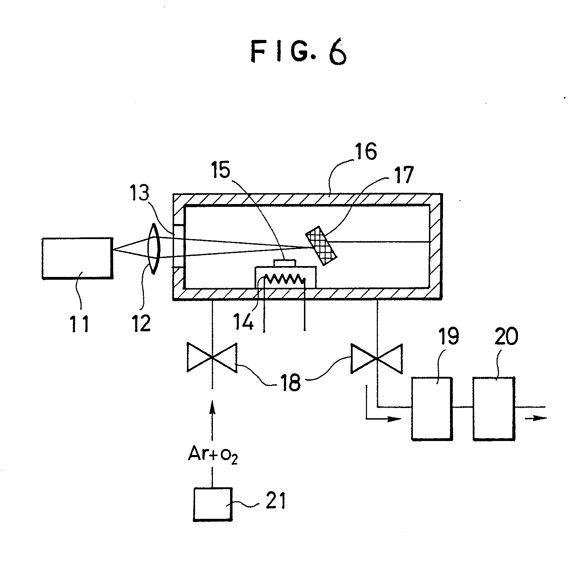

$Bi_2O_3$, $SrCO_3$, $La_2O_3$, and $CuO$ powders of 99.9% purity were prepared and mixed with each other so that $Bi:Sr:La:Cu = 2:3.5:0.5:3$. The mixture was compressed into a tablet and fired at 850°C for 24 hours. Then a substrate of $Bi_2(Sr_{1-x}La_{x4}Cu_3O_y$ was obtained. The substrate was disposed in a laser sputtering apparatus as illustrated in Fig.6. The apparatus comprises a vacuum chamber 16, a gas feeding system 21, an exhaust system comprising a turbo molecular pump 19 and a rotary pump 20, a substrate holder provided with a heater 14 therein, an excimer laser 11 and an associated lens 12 which focuses the laser rays emitted from the laser 11 through a light window 3 to a target 17 appropriately positioned in the chamber. The target 17 was prepared from a Bi-based superconductor of $Bi_2Sr_2Ca_2Cu_3O_y$ in accordance with the foregoing description.

After introducing argon and oxygen at $Ar:O_2 = 4:1$ and maintaining the whole pressure at 0.1 Torr, the target 17 was slowly disintegrated by bombardment with laser radiation and the material of the target was deposited on the substrate 15 of $Bi_2(Sr_{1-x}La_x)_4Cu_3O_y$. The substrate temperature was adjusted to 650°C by means of the heater 14. The deposition speed was about 10 nm/min. The thickness of the deposited film was 500 nm. By measurement of resistivity as a function of temperature, Tc was measured to be 106°K. This high Tc was attributed to an abundance of the high Tc phase in the superconductor.

Example 8:

The ceramics represented by $Bi_2Sr_4FE_3O_y$ (y = 8-12) have the same structure as the high Tc phase of the Bi-based superconducting ceramics. The a-axis and b-axis lengths are 5.4 Å and 3.6 Å, which are equal to the corresponding figures for the Bi-based superconducting ceramics. In this ceramic structure, Fe and Sr atoms replace the Cu and Ca sites of the Bi-based superconducting ceramics.

$Bi_2O_3$, $SrCO_3$, $La_2O_3$, and $CuO$ powders of 99.9% purity were prepared and mixed with each other so that $Bi:Sr:La:Cu = 2:3.5:0.5:3$. The mixture was compressed into a tablet and fired at 850°C for 24 hours. Then a substrate of $Bi_2Sr_4Fe_3O_y$ was obtained. This substrate was disposed in a laser sputtering apparatus as illustrated in Fig.6. The target 17 was prepared from a Bi-based superconductor ($Bi_2Sr_2Ca_2Cu_3O_y$) in accordance with the foregoing description.

After introducing argon and oxygen at $Ar:O_2 = 4:1$ and maintaining the whole pressure at 0.1 Torr, the target 17 was slowly disintegrated by bombardment with laser radiation and the material of the target was deposited on the substrate 15 of $Bi_2Sr_4Fe_3O_y$. The substrate temperature was adjusted to 650°C by means of the heater. By measurement of resistivity as a function of temperature, Tc was measured to be 106°K. This Tc was attributed to an abundance of the high Tc phase in the formed superconductor.

While several embodiments have been specifically described by way of example, it is to be appreciated that the present invention is not limited to the particular examples described and that modifications and variations can be made without departing from the scope of the invention as defined by the appended claims. For example, while three methods were employed for forming the superconductors in the foregoing embodiments, superconductors can be formed in accordance with the teachings of the present invention by other methods such as vacuum evaporation, reactive evaporation, chemical vapor reaction, spray pyrolysis, etc.

## Claims

1. A method of manufacturing a superconducting material of a predetermined molecular structure in accordance with which method a more readily available starting material having a structure similar to or bearing a predetermined relationship to that of the required superconducting material is utilized to initiate and/or encourage the development of the superconducting material in the required molecular structure.

2. A method of manufacturing a superconducting ceramic material, said method comprising:
preparing a substrate made of a more readily available ceramic material which has a similar crystalline structure to that of the superconducting ceramic material that is required to be manufactured; and
forming the required superconducting ceramic material on said substrate.

3. The method of claim 2 wherein the a-axis length and the b-axis length of the ceramic material forming said substrate are substantially the same as those of said superconducting ceramic material.

4. The method of claim 3 wherein the c-axis length of the ceramic material forming said substrate is close to that of said superconducting ceramic material or bears a predetermined ratio thereto.

5. The method of any of claims 2 to 4 wherein said forming step is carried out by screen printing.

6. The method of any of claims 2 to 4 wherein said forming step is carried out by laser sputtering.

7. The method of any of claims 2 to 6 wherein the ceramic material forming said substrate and said superconducting ceramic material are Bi-based oxide ceramics.

8. The method of claim 7 wherein the ceramic material forming said substrate is represented by the general formula $(Bi_2O_2)(A_{m-1}B_mO_{3m+1})$ where m > 1, A represents an alkaline earth metal and B represents a rare earth element.

9. The method of claim 7 wherein the ceramic material forming said substrate is selected from the group comprising $Bi_2(Sr_{1-x}La_x)_4Cu_3O_y$, $Bi_4Ti_3O_{12}$, $CaBi_4Ti_4O_{15}$, $SrBi_4Ti_4O_{15}$, $BaBi_4Ti_4O_{15}$, $PbBi_4Ti_4O_{15}$, $Sr_2Bi_4Ti_5O_{18}$, $Ba_2Bi_4Ti_4O_{18}$ and $Pb_2Bi_4Ti_5O_{18}$.

10. A method of manufacturing a crystalline superconducting ceramic material, said method comprising:
preparing a seed crystal of a more readily available ceramic material which has a similar crystalline structure to that of the superconducting ceramic material required to be manufactured; and

forming a single crystal superconducting ceramic material by means of a crystal pulling technique utilizing said seed crystal.

11. The method of claim 9 wherein the ceramic material forming said seed crystal is selected from among the group comprising $Bi_3TiNbO_9$, $Bi_3TiTaO_9$, $Bi_3Ti_4NbO_9$, $CaBi_2Nb_2O_9$, $Bi_3TiTaO_9$, $CaBi_2Ta_2O_9$, $SrBi_2Nb_2O_9$, $SrBi_2Ta_2O_9$, $Ba_2Bi_2Nb_2O_9$, $CaSr_2Bi_4Ti_5O_{18}$, $Sr_2Bi_4Ti_5O_{18}$, $Ba_2Bi_4Ti_5O_{18}$ and $Pb_2Bi_4Ti_5O_{18}$.

12. The method of claim 9 wherein the ceramic material forming said seed crystal comprises $Bi_2LaCa_nCu_nO_y$ ($n = 1, 2$ or $3$; $y = 8\text{-}12$).

# FIG. 1

# F I G. 2

# F I G. 3

# FIG. 4

# F I G. 5

# F I G. 6